# EUROPÄISCHE PATENTSCHRIFT

(11) **EP 4 174 233 B1**
(45) Veröffentlichungstag und Bekanntmachung des Hinweises auf die Patenterteilung: **17.09.2025**
(21) Anmeldenummer: 22175425.2
(22) Anmeldetag: 25.05.2022
(51) Int. Cl.: E02F 9/08, E02F 9/20, E02D 3/046

(54) **ELEKTRISCHE ARBEITSMASCHINE MIT AKKUKÜHLUNG**
ELECTRIC MACHINE TOOL WITH BATTERY COOLING
MACHINE DE TRAVAIL ÉLECTRIQUE À REFROIDISSEMENT D'ACCUMULATEUR

(30) Priorität: 29.10.2021 DE 102021128350
(43) Veröffentlichungstag der Anmeldung: 03.05.2023
(73) Patentinhaber: Wacker Neuson Produktion GmbH & Co. KG, 85084 Reichertshofen (DE)
(72) Erfinder: GALLE, Steffen, 84034 Landshut (DE); BACHMANN, Matthias, 86633 Neuburg (DE); WEISKOPF, Alto, 85250 Altomünster (DE); HARTMANN, Robert, 80939 München (DE); FORSTNER, Florian, 84104 Rudelzhausen (DE); KOLLMANN, Markus, 4072 Alkoven (AT)
(74) Vertreter: Müller Hoffmann & Partner

(56) Entgegenhaltungen:
- EP-A1- 2 584 100
- EP-B1- 2 857 587
- WO-A1-2021/173951

## Beschreibung

Die Erfindung betrifft eine Arbeitsmaschine, insbesondere eine akkubetriebene Baumaschine mit Elektroantrieb.

Akkubetriebene Baumaschinen weisen einen Antriebsstrang auf, mit einem Elektromotor, einem Energiespeicher (Akku) und einem Umformer. Der Umformer wandelt den Strom aus dem Energiespeicher (üblicherweise ein Gleichstrom) in einen zum Versorgen des Elektromotors geeigneten Strom, z.B. einen Wechselstrom. Die Komponenten müssen effizient gekühlt werden, damit die Baumaschine zuverlässig arbeiten kann. Dies gilt vor allem für den Akku, dessen Zellen bei übermäßiger Wärmeeinwirkung dauerhaften Schaden nehmen können, was nicht nur die Speicherkapazität, sondern auch die Lebensdauer des Akkus vermindern kann.

Zur Kühlung von Akku und Umformer ist es bekannt, an dem als Antriebsmotor dienenden Elektromotor der Baumaschine ein Lüfterrad vorzusehen, das einen Luftstrom erzeugt. Der Luftstrom kann dann nicht nur über den Antriebsmotor, sondern auch über den Akku und den Umformer geführt werden, um eine geeignete Kühlung beim Betrieb der Baumaschine zu bewirken.

Je nach Typ der Baumaschine ist es möglich, dass der Akku und der Umformer mit einiger Entfernung zum Elektromotor angeordnet sind. Für diesen Fall ist es notwendig, dass der Kühlluftstrom über Kühlkanäle (Luftführungskanäle) geleitet wird, damit der am Antriebsmotor durch den dort vorhandenen Lüfter erzeugte Kühlluftstrom auch auf Akku und Umformer wirkt. Je nach Länge und Gestaltung der Luftführungskanäle kann die Kühlwirkung am Akku und am Umformer nur gering sein.

Die Kühlwirkung wird nur während des Betriebs des Antriebsmotors erreicht, weil auch nur dann das Lüfterrad angetrieben wird. In anderen Betriebssituationen besteht daher das Risiko einer zu starken Wärmeeinwirkung auf Akku oder Umformer, wenn der Antriebsmotor nicht im Betrieb ist und damit kein Kühlluftstrom erzeugt wird.

Aus der EP 2 857 587 B1 ist eine Bodenverdichtungsvorrichtung mit einem luftgekühlten Akku bekannt. Dabei ist eine Luftfördereinrichtung vorgesehen, die ein Lüfterrad aufweist, das an oder auf einer Motorwelle des Antriebs angeordnet sein kann.

Der Erfindung liegt die Aufgabe zugrunde, eine Arbeitsmaschine anzugeben, mit einer verbesserten Kühlung für Akku und Umformer.

Die Aufgabe wird durch eine Arbeitsmaschine mit den Merkmalen von Anspruch 1 gelöst. Vorteilhafte Ausgestaltungen sind in den abhängigen Ansprüchen angegeben.

Es wird eine Arbeitsmaschine angegeben, mit einer Arbeitsvorrichtung zum Bewirken einer Arbeitsbewegung und mit einem Antrieb zum Antreiben der Arbeitsvorrichtung, wobei der Antrieb einen elektrischen Arbeitsmotor, einen elektrischen Energiespeicher zum Versorgen des Antriebsmotors mit elektrischem Strom und eine Umformereinrichtung zum Umformen des Stroms aus dem Energiespeicher und Zuführen des Stroms zu dem Antriebsmotor aufweist. Dabei ist eine Kühlvorrichtung vorgesehen, zum Kühlen des Energiespeichers und der Umformereinrichtung, wobei die Kühlvorrichtung wenigstens eine Lüftereinrichtung aufweist, zum Erzeugen eines Kühlluftstroms, der über den Energiespeicher und die Umformereinrichtung führbar ist, wobei die Lüftereinrichtung einen Lüfter und einen den Lüfter antreibenden Lüftermotor aufweist, und wobei der Lüftermotor getrennt von dem Antriebsmotor des Antriebs vorgesehen ist.

Bei der Arbeitsmaschine kann es sich z.B. um einen Vibrationsstampfer (Rüttelstampfer) oder um eine Vibrationsplatte (Rüttelplatte) zur Bodenverdichtung handeln. Dementsprechend kann die Arbeitsbewegung eine Stampfbewegung oder Rüttelbewegung sein, die in an sich bekannter, geeigneter Weise z.B. in den Boden eingelassen wird. Auch andere Baumaschinen können als derartige Arbeitsmaschinen eingesetzt werden.

Bei dem Energiespeicher kann es sich um einen Akku bzw. eine wiederaufladbare Batterie mit an sich bekannter Bauart handeln.

Die Umformereinrichtung kann z.B. ein Frequenzumformer sein, der geeignet ist, um die Spannung und Frequenz des aus dem Energiespeicher zugeführten Stroms umzuformen, zu einem Strom, der für den Betrieb des elektrischen Antriebsmotors (Elektromotors) geeignet ist.

Der Lüfter kann als Ventilator oder Propeller oder andere Einrichtung ausgebildet sein, die durch den Lüftermotor angetrieben wird, um den gewünschten Kühlluftstrom zu erzeugen.

Der Lüftermotor selbst kann ebenfalls ein Elektromotor sein. Er ist zusätzlich zum Antriebsmotor vorgesehen und kann in der Nähe oder auch entfernt vom Antriebsmotor an der Arbeitsmaschine angeordnet sein.

Zur Führung des Kühlluftstroms können geeignete Luftführungskanäle wie Schläuche, Rohre oder auch geeignet gestaltete Gehäuseelemente vorgesehen sein.

Dabei ist es wichtig, dass der Kühlluftstrom über den Energiespeicher und die Umformereinrichtung geführt werden kann. Insbesondere sollte der Kühlluftstrom entlang der Außenwände von Energiespeicher und Umformereinrichtung, also entlang dem Gehäuse geführt werden. Ebenso ist es aber auch möglich, dass der Kühlluftstrom durch die jeweiligen Gehäuse geführt wird, um die Wärme enthaltenden Komponenten bestmöglich zu erreichen, damit eine wirksame Kühlung erzielt werden kann.

Es ist möglich, mehrere Lüftereinrichtungen mit mehreren Lüftern und/oder Lüftermotoren vorzusehen, um ein flexibles Kühlkonzept vorzusehen. Die Kühlvorrichtung kann über die dann die mehreren Lüfter in geeigneter Weise verfügen und die Lüfter z.B. auch individuell ansteuern.

Eine elektrische Versorgung des Lüftermotors bzw. der gegebenenfalls mehreren Lüftermotoren kann mit Hilfe der Energie aus dem elektrischen Energiespeicher erfolgen.

Je nach Gestaltung der Arbeitsmaschine ist es möglich, dass für den eigentlichen Antriebsmotor keine Kühlung vorgesehen ist, sondern dass die Kühlung allein für die Komponenten Energiespeicher und Umformereinrichtung erfolgt. Die Kühlung des Antriebsmotors kann dann immanent durch Konvektion oder Strahlung möglich sein.

Der Kühlluftstrom kann zwischen dem Energiespeicher und der Umformereinrichtung geführt sein. Dabei ist es möglich, den Kühlluftstrom - je nach Gestaltung - in beide Richtungen zu führen, also entweder zunächst über den Energiespeicher und dann stromab vom Energiespeicher über die Umformereinrichtung oder in umgekehrter Richtung. Da der Energiespeicher die häufig sehr wärmesensitiven Zellen der Batterie umfasst, kann es zweckmäßig sein, die aus der Umgebung angesaugte Kühlluft zunächst über den Energiespeicher und erst danach, wenn sie schon die Wärme des Energiespeichers aufgenommen hat, über den Umformer zu führen.

Der Lüfter kann im Kühlluftstrom zwischen dem Energiespeicher und der Umformereinrichtung angeordnet sein. Der Lüfter dient zum Erzeugen des Kühlluftstroms und bewirkt je nach Strömungsrichtung einen Saugeffekt oder einen Gebläseeffekt (Drücken der Kühlluft in Stromab-Richtung). Die Anordnung des Lüfters zwischen Energiespeicher und Umformereinrichtung ermöglicht einen besonders kompakten Aufbau. Gleichzeitig ist es möglich, den Lüfter relativ klein auszuführen, weil beide Strömungsseiten (stromauf und stromab vom Lüfter) genutzt werden, um den Kühlluftstrom zu erzeugen und die jeweils dort angeordnete Komponente zu kühlen.

Es kann eine Lüftungssteuerungseinrichtung vorgesehen sein, um Ansteuern des Lüftermotors. Die Lüftungssteuerungseinrichtung kann den Lüftermotor insbesondere unabhängig vom eigentlichen Antriebsmotor der Arbeitsmaschine ansteuern. Insbesondere erlaubt die Steuerung ein temperaturabhängiges Ein- und Ausschalten des Lüftermotors und somit kein betriebsabhängiges Schalten des Lüftermotors in Abhängigkeit vom Ein- und Ausschalten des Antriebsmotors.

Als maßgebliche Temperatur kann die Lüftungssteuerungseinrichtung z.B. die Temperatur in der Umgebung, am bzw. im Umformer und/oder am oder im Energiespeicher berücksichtigen. Auch ist es möglich, die Lüfterdrehzahl in Abhängigkeit von der Temperatur zu regeln, um einen unnötig starken Betrieb der Kühlvorrichtung und damit auch einen unnötigen Energieverbrauch zu vermeiden.

Auf diese Weise kann eine bedarfsgerechte Kühlung des Energiespeichers und der Umformereinrichtung erreicht werden. Dadurch lässt sich eine frühzeitige Zellalterung in dem Energiespeicher vermeiden, wodurch die Energie- und Leistungskapazität der Zellen gesteigert werden kann.

Die erforderliche Stromversorgung der Lüftungssteuerungseinrichtung wie auch der Lüftereinrichtung kann ebenfalls über den Energiespeicher und gegebenenfalls auch über die Umformereinrichtung bereitgestellt werden.

Bei einer Ausführungsform der Arbeitsmaschine können eine Obermasse und eine Untermasse vorgesehen sein, wobei die Untermasse relativ zu der Obermasse bewegbar ist, wobei an der Obermasse der Energiespeicher, die Umformereinrichtung und die Kühlvorrichtung angeordnet sind, und wobei an der Untermasse eine Bodenkontaktplatte vorgesehen sein kann, zum Ausführen der Arbeitsbewegung.

Diese Arbeitsmaschine kann z.B. als Stampfer oder Rüttelplatte bzw. Vibrationsplatte ausgeführt sein. Dementsprechend kann die Arbeitsvorrichtung zwischen Obermasse und Untermasse wirken und z.B. als Stampfvorrichtung oder als Schwingungserreger ausgebildet sein. Zwischen Obermasse und Untermasse kann eine Federeinrichtung bzw. eine Feder-Dämpfereinrichtung vorgesehen sein, um eine Schwingungsentkopplung zwischen Obermasse und Untermasse zu erreichen und die Relativbeweglichkeit zu ermöglichen.

Der Antriebsmotor kann je nach Ausführungsform an der Obermasse oder an der Untermasse angeordnet sein. Bei einem Stampfer wird es sinnvoll sein, den Antriebsmotor an der Obermasse anzuordnen und die Antriebsbewegung des Antriebsmotors über eine als Arbeitsvorrichtung dienende Stampfvorrichtung auf die Untermasse mit der Bodenkontaktplatte zu übertragen.

Dieses Prinzip ist auch bei einer Vibrationsplatte realisierbar, bei der die Antriebsbewegung des Antriebsmotors an der Obermasse dann auf den Schwingungserreger an der Untermasse übertragen werden muss.

Bei einer Variante kann der Antriebsmotor auch direkt an der Untermasse, z.B. direkt auf der Bodenkontaktplatte angebracht sein und dort mit einem Schwingungserreger gekoppelt werden.

Die Obermasse kann eine Griffeinrichtung aufweisen, zum Führen der Arbeitsmaschine durch einen Benutzer, wobei der Energiespeicher und die Lüftereinrichtung an der Griffeinrichtung angeordnet sein können. Bei dieser Ausführungsform kann die Arbeitsmaschine z.B. als Stampfer ausgebildet sein. Die Griffeinrichtung, z.B. ein an sich bekannter Griffbügel, kann vom Rest der Obermasse durch eine Schwingungsentkopplungseinrichtung entkoppelt sein, um den die Griffeinrichtung greifenden Benutzer vor starken Schwingungen zu schützen, so dass die auf den Benutzer einwirkenden Hand-Arm-Vibrationen unterhalb von zulässigen Grenzwerten bleiben.

Der Energiespeicher und die Lüftereinrichtung können an der Griffeinrichtung angebracht sein bzw. von der Griffeinrichtung getragen werden. Da die Griffeinrichtung, wie oben dargelegt, schwingungsentkoppelt sein kann, werden dann auch der Energiespeicher und die Lüftereinrichtung nur geringen Schwingungen ausgesetzt, was ihre Lebensdauer erhöht bzw. keine weiteren Schwingungsentkopplungsmaßnahmen erfordert. Umgekehrt trägt die durch den Energiespeicher und den Lüfter bewirkte höhere Masse an der Griffeinrichtung auch zu einer besseren Schwingungsreduzierung am Griffbügel bei.

Die Umformereinrichtung kann an der Griffeinrichtung angeordnet sein. Das bedeutet, dass der Umformer zusätzlich zum Energiespeicher und zum Lüfter ebenfalls von dem Griffbügel getragen werden kann.

An der Griffeinrichtung kann eine Abdeckung vorgesehen sein, wobei der Energiespeicher und/oder die Lüftereinrichtung und/oder die Umformereinrichtung unter der Abdeckung angeordnet sein können. Die Abdeckung dient als Schutz, insbesondere für den Energiespeicher und den Umformer. Zudem können in der Abdeckung geeignete Luftführungskanäle ausgebildet sein, um die von der Lüftereinrichtung geförderte Kühlluft zu den zu kühlenden Komponenten zu führen.

Die Arbeitsmaschine kann eine Bodenverdichtungsvorrichtung sein. Insbesondere kann die Arbeitsmaschine eine Stampfvorrichtung oder eine Vibrationsplatte zur Bodenverdichtung sein.

Insbesondere kann die Arbeitsmaschine eine Obermasse und eine relativ zu der Obermasse bewegbare Untermasse aufweisen.

An der Obermasse kann eine Luftführungseinrichtung vorgesehen sein, wobei der Kühlluftstrom wenigstens teilweise durch die Luftführungseinrichtung geführt wird, und wobei die Luftführungseinrichtung die Umformereinrichtung trägt.

Die Luftführungseinrichtung hat in diesem Fall wenigstens zwei Funktionen, nämlich das Führen des Kühlluftstroms und das Tragen des Umformers. Zudem ist es optional möglich, dass die Luftführungseinrichtung auch die Lüftereinrichtung und/oder Versorgungsleitungen bzw. Elektrokabel trägt und führt, die z.B. zu der Umformereinrichtung geführt werden müssen. Die Luftführungseinrichtung kann somit als Multifunktionsteil ausgebildet sein.

Z.B. kann die Luftführungseinrichtung als eine Einheit an der Obermasse befestigbar sein, so dass die Luftführungseinrichtung mit den von ihr getragenen Komponenten gemeinsam an der Obermasse befestigt werden kann.

Der Kühlluftstrom kann dabei wenigstens teilweise durch die Luftführungseinrichtung geführt werden. Er kann aber auch noch in anderen Bereichen bzw. durch andere Bereiche der Arbeitsmaschine strömen.

Zwischen der Luftführungseinrichtung und der Obermasse kann eine Schwingungsentkopplungseinrichtung vorgesehen sein. Damit kann die Luftführungseinrichtung mit der Lüftereinrichtung (sofern vorhanden) und der Umformereinrichtung schwingungsentkoppelt von der restlichen Obermasse an der Obermasse befestigt sein. Als Schwingungsentkopplungseinrichtung eignen sich z.B. Gummipuffer oder Schaumpolster.

Der Energiespeicher kann in einer Akkuaufnahme gehalten sein, wobei die Akkuaufnahme und die Luftführungseinrichtung miteinander gekoppelt sein können, und wobei die Akkuaufnahme und die Luftführungseinrichtung gemeinsam durch die Schwingungsentkopplungseinrichtung schwingungsentkoppelt an der Obermasse befestigt sein können.

Dabei kann der Energiespeicher in der Akkuaufnahme auswechselbar gehalten werden und z.B. durch einen frischen Energiespeicher ausgetauscht werden. Die Akkuaufnahme und die Luftführungseinrichtung können fest mechanisch miteinander verbunden sein.

Die Luftführungseinrichtung kann eine Trägerstruktur und eine Abdeckeinrichtung aufweisen, die zu einer Einheit zusammenmontierbar sind. Dabei kann die Trägerstruktur ausgebildet sein zum Tragen der Lüftereinrichtung und der Umformereinrichtung, wobei die Trägerstruktur und die Abdeckeinrichtung im zusammengebauten Zustand einen Luftkanal bilden, der sich wenigstens zwischen der Lüftereinrichtung und der Umformereinrichtung erstreckt. Der Luftkanal kann dementsprechend zum Führen des Kühlluftstroms genutzt werden. Die Luftführungseinrichtung kann somit zwei Komponenten aufweisen, die zu einer Einheit zusammengebaut werden und auch als Gehäusekomponenten für den Luftkanal dienen können.

Die Trägerstruktur kann zusammen mit der Luftführungseinrichtung und der Umformereinrichtung als eine Einheit an der Obermasse befestigbar sein. Somit ist es möglich, die Lüftereinrichtung und die Umformereinrichtung auf der Trägerstruktur zu montieren und dann die Trägerstruktur an der Obermasse zu befestigen. Dies kann auch mit bereits aufgesetzter und montierter Abdeckeinrichtung erfolgen.

Die Luftführungseinrichtung kann eine stromauf von der Lüftereinrichtung vorgesehene Lufteintrittsöffnung aufweisen, die stromab von dem Energiespeicher angeordnet ist. Über die Lufteintrittsöffnung kann dann im Betrieb durch die Lüftereinrichtung Luft angesaugt werden, die vorher durch den Energiespeicher strömt und diesen dabei kühlt. Selbstverständlich ist es auch in diesem Fall möglich, dass der Kühlluftstrom durch den Energiespeicher hindurch oder an Gehäusewänden des Energiespeichers entlang geführt wird.

Die Luftführungseinrichtung kann eine stromab von der Umformereinrichtung vorgesehene, nach unten gerichtete Luftaustrittsöffnung aufweisen. Dabei kann die nach unten gerichtete Luftaustrittsöffnung auch schräg nach unten gerichtet sein, so dass der dort austretende Luftstrom gezielt an weitere Stellen geführt werden kann. Insbesondere kann der an der Luftaustrittsöffnung austretende Kühlluftstrom zu weiteren Komponenten der Arbeitsmaschine geführt werden, wie z.B. zu einem Schwingungserreger oder einem Elektroantrieb des Schwingungserregers, wie später noch erläutert wird.

In der Obermasse kann eine Öffnung vorgesehen sein, durch die sich die Luftführungseinrichtung nach unten in Richtung der Untermasse erstreckt. Auf diese Weise können die Voraussetzungen geschaffen werden, dass über die Luftführungseinrichtung ein Kühlluftstrom auch zu Komponenten an der Untermasse geführt wird.

Dieser Aufbau eignet sich besonders für eine als Rüttelplatte bzw. Vibrationsplatte ausgeführte Arbeitsmaschine.

Dabei kann die Untermasse einen auf der Bodenkontaktplatte angeordneten Schwingungserreger aufweisen, zum Erzeugen von Schwingungen, die durch die Bodenkontaktplatte zur Bodenverdichtung nutzbar sind, wobei der Kühlluftstrom über die Luftaustrittsöffnung austreten und in Richtung des an der Untermasse vorgesehenen Schwingungserregers geführt werden kann.

Die Luftführungseinrichtung kann dabei stromab von der Umformereinrichtung einen Luftkanalabschnitt aufweisen, zum Führen des Kühlluftstroms in Richtung des Schwingungserregers, um diesen zu kühlen. Insbesondere kann dabei eine Strömungsrichtung für den Kühlluftstrom in Richtung eines den Schwingungserreger antreibenden Antriebsmotors, z.B. eines Hydraulikmotors oder Elektromotors, erzeugt werden.

Ein typischer Schwingungserreger weist dabei die eigentliche Erregereinrichtung, z.B. mit einer oder mehreren jeweils eine Unwuchtmasse tragenden Unwuchtwellen, sowie einen Antriebsmotor für die Erregereinrichtung auf.

Zunehmend ist es möglich, dass die Unwuchtwelle bzw. die Unwuchtwellen in der Erregereinrichtung direkt durch einen Elektromotor angetrieben werden. Der Elektromotor kann in geeigneter Weise, z.B. auf Anschraubdomen schwebend, auf der Bodenkontaktplatte angebracht werden, so dass er an mehreren Seiten, insbesondere auch an seiner Unterseite, von dem über die Luftführungseinrichtung zugeführten Kühlluftstrom gekühlt werden kann. Dabei ist es anzustreben, dass der Elektromotor bestmöglich gekühlt wird und dass, sofern technisch möglich, der Kühlluftstrom auch durch das Innere des Motors bzw. dessen Motorwicklung geführt wird. Die Kontur der Erregereinrichtung bzw. des Motorgehäuses des Elektromotors kann dabei so geformt sein, dass sich dort eine bestmögliche Luftführung über das Motorgehäuse bzw. über die Erregereinrichtung ergibt.

Die Kühlvorrichtung kann wenigstens zwei Lüftereinrichtungen aufweisen, wobei die von den beiden Lüftereinrichtungen erzeugten Luftströme zu einem gemeinsamen Kühlluftstrom zusammenführbar sind. Dabei können die Lüftereinrichtungen parallel zueinander angeordnet sein und jeweils Einzel-Luftströme erzeugen, die dann über die Luftführungseinrichtung zu einem gemeinsamen Kühlluftstrom zusammengeführt werden.

Diese Variante ermöglicht es, die Lüftereinrichtungen relativ kompakt und klein aufzubauen und doch in Summe einen wirkungsvollen Kühlluftstrom zu erzeugen.

Stromauf von dem Energiespeicher kann an einer Oberseite der Obermasse eine Ansaugöffnung für den Kühlluftstrom vorgesehen sein. Die Ansaugöffnung kann dabei im Wesentlichen vertikal nach oben gerichtet sein. Die Oberseite der Obermasse wird im Betrieb der Rüttelplatte relativ gut vor Staub und Schmutz geschützt sein, so dass über die dort vorgesehene Ansaugöffnung vergleichsweise wenig Staub in die Luftführungseinrichtung gezogen wird. Die Ansaugöffnung kann durch Gitter oder Umlenklamellen zusätzlich geschützt werden, um das Eindringen von Staub zu verringern.

Somit wird eine Arbeitsmaschine angegeben, bei der frische Umgebungsluft an einer Stelle angesaugt wird, an der am wenigsten Staub in der Luft zu erwarten ist. Diese Luft wird dann als Kühlluftstrom in den Energiespeicher (Akku) gezogen und durch die Lüftereinrichtung (oder die mehreren Lüftereinrichtungen) in der Luftführungseinrichtung auf die Umformereinrichtung geblasen. Der Querschnitt der luftführenden Kanäle in der Luftführungseinrichtung verändert sich dabei so, dass die Umformereinrichtung eine optimale Kühlwirkung erfährt.

Unterhalb von der Obermasse kann sich die Luftaustrittsöffnung der Luftführungseinrichtung befinden. Dort kann die Luft direkt auf den Schwingungserreger mit dem dort verbauten Motor geleitet werden, um auch hier eine möglichst optimale Kühlung zu erreichen.

Die vorgesehene Kühlvorrichtung kühlt auf diese Weise alle in der Arbeitsmaschine vorhandenen Komponenten, die eine nennenswerte Verlustleistung im Betrieb erzeugen. Dabei ist die Reihenfolge der Kühlung, also der Verlauf des Kühlluftstroms, so gewählt, dass zunächst die Komponente gekühlt wird, die die niedrigste zulässige Temperatur aufweist (z.B. der Energiespeicher). Die letzte Komponente im Kühlluftstrom hingegen kann die höchste zulässige Temperatur ertragen (z.B. der Elektromotor im Schwingungserreger). Gleichzeitig wird die Luft so geleitet, dass sie bei einer maximal zulässigen Umgebungstemperatur von z.B. 45° die Verlustleistung der jeweiligen Komponente, an der sie vorbeigeführt wird, präzise ableiten kann. Diese ausgeglichene und optimierte Kühlleistung ermöglicht es, besonders schwache Lüfter zu verwenden, die ihrerseits nur geringe Leistungsanforderungen stellen, die im Betrieb aus dem Energiespeicher befriedigt werden müssen.

Mithilfe der Erfindung ist es möglich, das Thermomanagement bei einer Arbeitsmaschine zu verbessern, um ein Überhitzen des Akkus und auch des Umformers zu vermeiden und somit für eine Schonung und eine Verlängerung der Lebensdauer des Akkus zu sorgen.

Durch die Nutzung von Lüftern, z.B. montiert am Griffbügel vor oder unterhalb des Umformers, kann der kühlende Luftstrom zunächst über den Akku angesaugt und danach über den Umformer geführt werden. Die Ansteuerung des Lüfters unabhängig vom Betriebszustand des Antriebsmotors kann den Einsatz auch in warmen Umgebungen, z.B. bei starker Sonneneinstrahlung, ermöglichen.

Diese und weitere Vorteile und Merkmale der Erfindung werden nachfolgend anhand von Beispielen unter Zuhilfenahme der begleitenden Figuren näher erläutert. Es zeigen:
- **Fig. 1**: in schematischer seitlicher Schnittdarstellung eine erfindungsgemäße Arbeitsmaschine als Rüttelstampfer;
- **Fig. 2**: in schematischer Seitenansicht eine andere erfindungsgemäße Arbeitsmaschine als Vibrationsplatte;
- **Fig. 3**: eine Variante zu einer Vibrationsplatte mit Luftführungseinrichtung; und
- **Fig. 4**: ein Detail zu der Variante von Fig. 3.

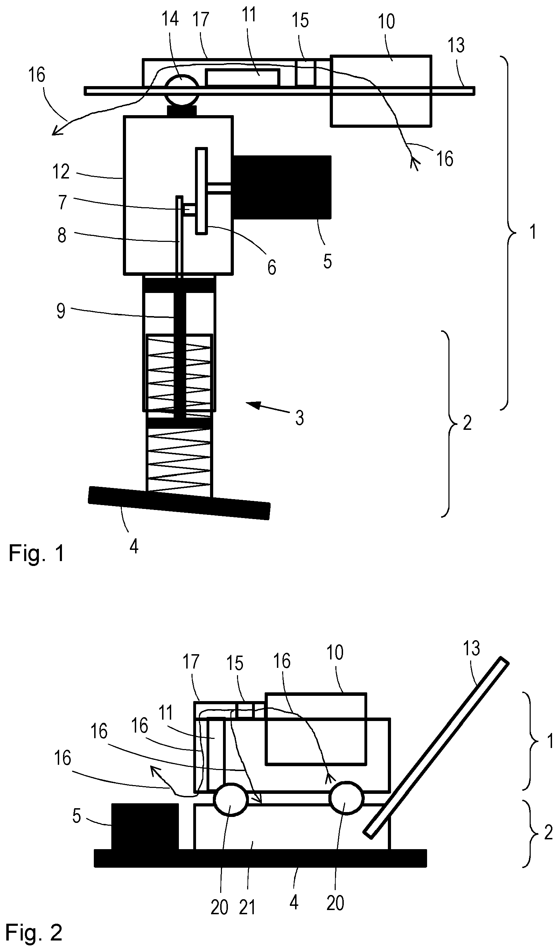

Fig. 1 zeigt schematisch einen Rüttel- bzw. Vibrationsstampfer, mit einer Obermasse 1 und einer relativ zu der Obermasse 1 bewegliche Untermasse 2. Die Obermasse 1 und die Untermasse 2 sind durch eine an sich bekannte Federeinrichtung 3 miteinander gekoppelt. An der Unterseite der Untermasse 2 ist eine Bodenkontaktplatte 4 zur Bodenverdichtung vorgesehen.

An der Obermasse 1 ist ein Antrieb mit einem Elektromotor 5 vorgesehen, der ein Kurbelrad 6 drehend antreibt, das über einen Kurbelzapfen 7 mit einem Pleuel 8 gekoppelt ist. Das Pleuel 8 ist mit einem Stampfkolben 9 verbunden, so dass die Drehbewegung des Kurbelrads 6 in eine Hin- und Herbewegung des Stampfkolbens 9 gewandelt wird. Die lineare Bewegung des Stampfkolbens 9 wird dann schließlich über die Federeinrichtung 3 auf die Bodenkontaktplatte 4 übertragen, die die eigentliche Stampfbewegung ausführt.

Zur Energieversorgung des Elektromotors 5 ist ein als elektrischer Energiespeicher dienender Akku 10 vorgesehen.

Der vom Akku 10 bereitgestellte elektrische Strom wird von einem als Umformereinrichtung dienenden Umformer 11 hinsichtlich seiner Spannung und seiner Frequenz in einem für den Elektromotor 5 geeignete Strom gewandelt bzw. umgeformt. Insbesondere kann es dabei möglich sein, aus dem im Akku 10 gespeicherten Gleichstrom einen Wechselstrom für den Elektromotor 5 zu erzeugen.

Das Kurbelrad 6, der Kurbelzapfen 7 und das Pleuel 8 sind in einem Kurbelgehäuse 12 untergebracht, an dem auch der Elektromotor 5 befestigt ist. Bei einer Variante kann der Elektromotor 5 auch weitgehend im Inneren des Kurbelgehäuses 12 angeordnet sein.

An der Oberseite des Kurbelgehäuses 12 ist eine zu der Obermasse 1 gehörende, als Griffbügel ausgebildete Griffeinrichtung 13 angebracht. Zur Schwingungsentkopplung der Griffeinrichtung 13 ist zwischen der Griffeinrichtung 13 und dem Kurbelgehäuse 12 eine Schwingungsentkopplungseinrichtung 14, z.B. in Form von Gummipuffern, angeordnet. Dadurch ist die Griffeinrichtung 13 in gewissen Grenzen relativ zu der restlichen Obermasse 1, insbesondere relativ zum Kurbelgehäuse 12 verschwenkbar, um einen Bediener, der den Griffbügel bzw. die Griffeinrichtung 13 bestimmungsgemäß am in Fig. 1 rechten Ende greift, vor der Einwirkung übermäßig starker Schwingungen zu schützen.

Sowohl der Akku 10 als auch der Umformer 11 sind an der Griffeinrichtung 13 befestigt bzw. werden von dieser getragen. Dabei ist es möglich, dass der Akku 10 wechselbar an der Griffeinrichtung 13 befestigt ist, so dass er jeweils durch einen frischen Akku 10 ersetzt werden kann.

Räumlich zwischen dem Akku 10 und dem Umformer 11 ist eine Lüftereinrichtung 15 angeordnet, die einen Lüfter, z.B. einen Ventilator, und einen Lüftermotor aufweist.

Die Lüftereinrichtung 15 erzeugt einen Kühlluftstrom 16, in dem sie Luft über den Akku 10 einsaugt und stromab über den Umformer 11 drückt, bis der Kühlluftstrom 16 wieder in die Umgebung gelangt. Der Verlauf des Kühlluftstroms 16 ist in Fig. 1 symbolhaft durch einen Pfeil dargestellt.

Zur besseren Führung des Kühlluftstroms 16 sowie zum Schutz der verschiedenen Komponenten ist eine Abdeckung 17, z.B. eine Kunststoffhaube, vorgesehen.

Bei einer nicht dargestellten Variante kann die Lüftereinrichtung 15 auch stromauf von dem Akku 10 oder stromab von dem Umformer 11 angeordnet sein, um den Kühlluftstrom 16 (vgl. Pfeilrichtung) in geeigneter Weise zu erzeugen.

Fig. 2 zeigt eine andere Ausführungsform der Arbeitsmaschine als Vibrationsplatte. Funktional ähnliche oder identische Komponenten wie bei der Ausführungsform von Fig. 1 werden mit gleichen Bezugszeichen bezeichnet.

Demgemäß weist die Vibrationsplatte ebenfalls eine Obermasse 1 und eine Untermasse 2 auf, wobei die Untermasse 2 relativ zu der Obermasse 1 beweglich ist. Dazu sind Schwingungsentkopplungselemente 20 zwischen der Obermasse 1 und der Untermasse 2 vorgesehen.

An der Untermasse 2 ist eine Bodenkontaktplatte 4 ausgebildet. Auf der Bodenkontaktplatte 4 ist der Elektromotor 5 angeordnet, der einen Schwingungserreger 21 antreibt. Der Schwingungserreger 21 kann z.B. eine oder mehrere Unwuchtwellen aufweisen, die durch den als Antriebsmotor dienenden Elektromotor 5 in Rotation versetzt werden, um die gewünschten Schwingungen zu erzeugen. Die Schwingungen werden dann über die Bodenkontaktplatte 4 direkt in den zu verdichtenden Boden eingeleitet.

Der die Energie für den Elektromotor 5 bereitstellende Akku 10 ist an der Obermasse 1 angeordnet, zusammen mit dem Umformer 11.

Wie bei der Ausführungsform von Fig. 1 ist zwischen dem Akku 10 und dem Umformer 11 die Lüftereinrichtung 15 angeordnet, um den Kühlluftstrom 16 durch den Akku 10 und entlang dem Umformer 11 zu bewirken. Wie erkennbar, kann der Kühlluftstrom 16 stromab von der Lüftereinrichtung 15 derart geführt, dass der Umformer 11 möglichst allseitig bzw. wenigstens beidseitig von Kühlluftstrom 16 umströmt wird. Je nach Ausgestaltung genügt aber auch die Kühlwirkung, wenn der Akku 10 und/oder Umformer 11 nur einseitig beströmt werden.

Zur verbesserten Führung des Kühlluftstroms 16 ist die Abdeckung 17 vorgesehen.

Die Griffeinrichtung 13 ist bei der Vibrationsplatte in Form einer durch einen Bediener führbaren Deichsel ausgebildet, die an der Untermasse 2 befestigt ist.

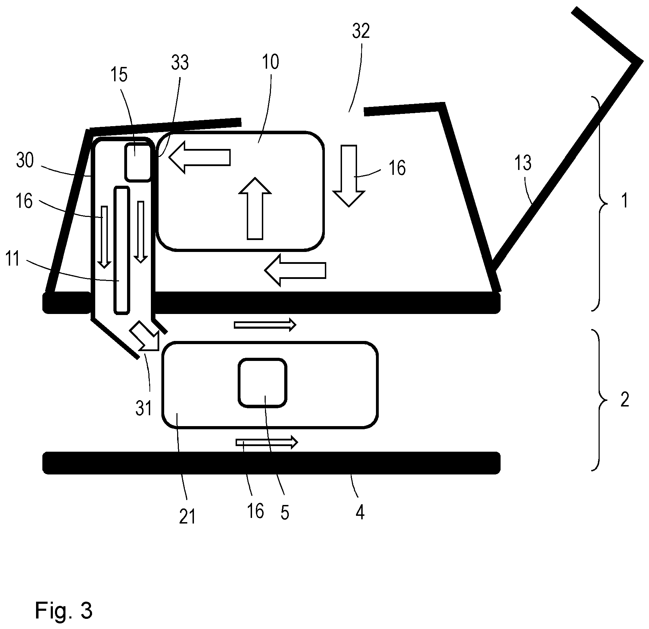

Fig. 3 zeigt in schematischer Seitenansicht eine Variante zu der Vibrationsplatte von Fig. 2.

Die Vibrationsplatte weist ebenfalls eine Obermasse 1 und eine Untermasse 2 auf. An der Untermasse 2 ist die Bodenkontaktplatte 4 vorgesehen, auf der der Schwingungserreger 21 angebracht ist. Der Schwingungserreger 21 weist nicht nur die eigentliche Erregereinheit auf, sondern auch integriert den Elektromotor 5.

An der Obermasse 1 ist der Akku 10 vorgesehen, sowie eine Luftführungseinrichtung 30.

Die Luftführungseinrichtung 30 ist eine kompakte Einheit, die sich mit einer vertikalen Komponente senkrecht erstreckt. In der Luftführungseinrichtung 30 ist die Lüftereinrichtung 15 zum Erzeugen des Kühlluftstroms 16 vorgesehen. Der Kühlluftstrom 16 ist in Fig. 3 durch mehrere unterschiedlich große Pfeile symbolisiert, wobei das Bezugszeichen 16 nicht an jedem Pfeil angetragen ist, um die Klarheit der Bilddarstellung nicht zu beeinträchtigen.

Weiterhin ist in der Luftführungseinrichtung 30 der Umformer 11 gehalten. Der Umformer 11 ist im Wesentlichen senkrecht angeordnet und wird beidseitig durch den Kühlluftstrom 16 angeströmt.

An ihrem unteren Ende durchstößt die Luftführungseinrichtung 30 die Obermasse 1 nach unten, so dass der Kühlluftstrom 16 über eine Luftaustrittsöffnung 31 ausgeführt werden kann.

Wie in Fig. 3 erkennbar, wird dabei der Kühlluftstrom 16 in Richtung des Schwingungserregers 21 und des Elektromotors 5 umgelenkt, so dass er dort noch zur Kühlung genutzt werden kann.

Der Schwingungserreger 21 bzw. der Elektromotor 5 sind auf der Bodenkontaktplatte 4 derart montiert, dass sie möglichst gut durch den Kühlluftstrom 16 umströmt werden können. Insbesondere kann vorgesehen sein, dass der Kühlluftstrom 16 auch unterhalb des Elektromotors 5, zwischen Elektromotor 5 und Bodenkontaktplatte 4 strömen kann, um die Kühlwirkung zu verbessern.

Am stromauf liegenden Ende ist an der Oberseite der Obermasse 1 eine Ansaugöffnung 32 ausgebildet, über die Kühlluft aus der Umgebung zuströmen kann. Die Anordnung der Ansaugöffnung 32 an der Oberseite ermöglicht es, dass die Kühlluft möglichst staub- und schmutzfrei in die Obermasse 1 eintritt.

Der Kühlluftstrom 16 wird nachfolgend an den Wänden des Akkus 10 bzw. durch den Akku 10 hindurchgeführt.

Die den Kühlluftstrom 16 erzeugende Lüftereinrichtung 15 ist im oberen Bereich der Luftführungseinrichtung 30 angeordnet. Stromauf von der Lüftereinrichtung 15 und stromab von dem Akku 10 ist eine Lufteintrittsöffnung 33 vorgesehen, über die der Kühlluftstrom 16 in die Luftführungseinrichtung 30 eintreten kann, nachdem er durch die Lüftereinrichtung 15 transportiert wurde.

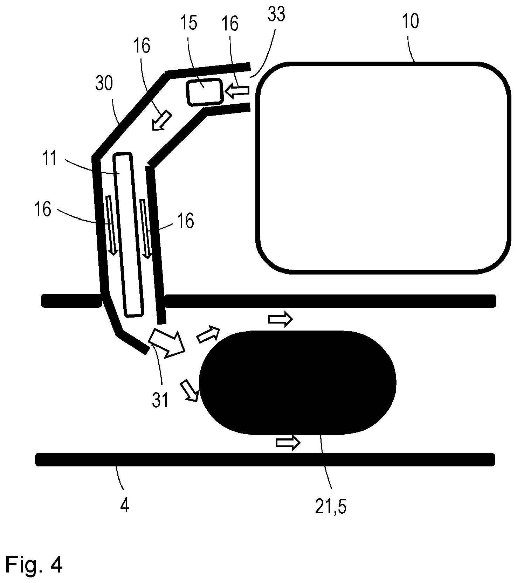

Fig. 4 zeigt den Zusammenhang von Fig. 3 in vergrößerter, reduzierter Darstellung.

Hierbei ist die Luftführungseinrichtung 30 bogenartig ausgebildet, um den Kühlluftstrom 16 sinnvoll entlang der Umformereinrichtung 11 entlangzuführen.

Auch hier ist erkennbar, wie der Kühlluftstrom 16 nach Austritt aus der Luftführungseinrichtung 30 über die Luftaustrittsöffnung 31 aufgeteilt wird, um den Schwingungserreger 21 mit dem Elektromotor 5 zu umströmen.

## Patentansprüche

1. Arbeitsmaschine, mit
- einer Arbeitsvorrichtung zum Bewirken einer Arbeitsbewegung; und mit
- einem Antrieb zum Antreiben der Arbeitsvorrichtung;
wobei
- der Antrieb einen elektrischen Antriebsmotor (5), einen elektrischen Energiespeicher (10) zum Versorgen des Antriebsmotors (5) mit elektrischem Strom und eine Umformereinrichtung (11) zum Umformen des Stroms aus dem Energiespeicher (10) und Zuführen des Stroms zu dem Antriebsmotor (5) aufweist;
- eine Kühlvorrichtung vorgesehen ist, zum Kühlen des Energiespeichers (10) und der Umformereinrichtung (11);
- die Kühlvorrichtung wenigstens eine Lüftereinrichtung (15) aufweist, zum Erzeugen eines Kühlluftstroms (16), der über den Energiespeicher (10) und die Umformereinrichtung (11) führbar ist;
- die Lüftereinrichtung (15) einen Lüfter und einen den Lüfter antreibenden Lüftermotor aufweist;
- der Lüftermotor getrennt von dem Antriebsmotor (5) des Antriebs vorgesehen ist;
- eine Obermasse (1) und eine Untermasse (2) vorgesehen sind;
- die Untermasse (2) relativ zu der Obermasse (1) bewegbar ist;
- an der Obermasse (1) der Energiespeicher (10), die Umformereinrichtung (11) und die Kühlvorrichtung angeordnet sind;
- an der Untermasse (2) eine Bodenkontaktplatte (4) vorgesehen ist, zum Ausführen der Arbeitsbewegung; **dadurch gekennzeichnet, dass**
- an der Obermasse (1) eine Luftführungseinrichtung (30) vorgesehen ist;
- der Kühlluftstrom (16) wenigstens teilweise durch die Luftführungseinrichtung (30) geführt wird; und wobei
- die Luftführungseinrichtung (30) die Umformereinrichtung (11) trägt.

2. Arbeitsmaschine nach Anspruch 1, wobei der Kühlluftstrom (16) zwischen dem Energiespeicher (10) und der Umformereinrichtung (11) geführt ist.

3. Arbeitsmaschine nach einem der vorstehenden Ansprüche, wobei der Lüfter im Kühlluftstrom (16) zwischen dem Energiespeicher (10) und der Umformereinrichtung (11) angeordnet ist.

4. Arbeitsmaschine nach einem der vorstehenden Ansprüche wobei zwischen der Luftführungseinrichtung (30) und der restlichen Obermasse (1) eine Schwingungsentkopplungseinrichtung vorgesehen ist.

5. Arbeitsmaschine nach einem der vorstehenden Ansprüche wobei
- der Energiespeicher (10) in einer Akkuaufnahme gehalten ist;
- die Akkuaufnahme und die Luftführungseinrichtung (30) miteinander gekoppelt sind; und wobei
- die Akkuaufnahme und die Luftführungseinrichtung (30) gemeinsam durch die Schwingungsentkopplungseinrichtung schwingungsentkoppelt an der Obermasse (1) befestigt sind.

6. Arbeitsmaschine nach einem der vorstehenden Ansprüche wobei
- die Luftführungseinrichtung (30) eine Trägerstruktur und eine Abdeckeinrichtung aufweist, die zu einer Einheit zusammen montierbar sind;
- die Trägerstruktur ausgebildet ist zum Tragen der Lüftereinrichtung (15) und der Umformereinrichtung (11); und wobei
- die Trägerstruktur und die Abdeckeinrichtung im zusammengebauten Zustand einen Luftkanal bilden, der sich wenigstens zwischen der Lüftereinrichtung (15) und der Umformereinrichtung (11) erstreckt.

7. Arbeitsmaschine nach einem der vorstehenden Ansprüche wobei die Trägerstruktur zusammen mit der Lüftereinrichtung (15) und der Umformereinrichtung (11) als eine Einheit an der Obermasse (1) befestigbar ist.

8. Arbeitsmaschine nach einem der vorstehenden Ansprüche wobei die Luftführungseinrichtung (30) eine stromauf von der Lüftereinrichtung (15) vorgesehene Lufteintrittsöffnung (33) aufweist, die stromab von dem Energiespeicher (10) anordenbar ist.

9. Arbeitsmaschine nach einem der vorstehenden Ansprüche wobei die Luftführungseinrichtung (30) eine stromab von der Umformereinrichtung (11) vorgesehene, nach unten gerichtete Luftaustrittsöffnung (31) aufweist.

10. Arbeitsmaschine nach einem der vorstehenden Ansprüche wobei in der Obermasse (1) eine Öffnung vorgesehen ist, durch die sich die Luftführungseinrichtung (30) nach unten in Richtung der Untermasse (2) erstreckt.

11. Arbeitsmaschine nach einem der vorstehenden Ansprüche wobei
- die Untermasse (2) einen auf der Bodenkontaktplatte (4) angeordneten Schwingungserreger (21) aufweist, zum Erzeugen von Schwingungen, die durch die Bodenkontaktplatte (4) zur Bodenverdichtung nutzbar sind; und wobei
- der Kühlluftstrom (16) über die Luftaustrittsöffnung (31) austritt und in Richtung des an der Untermasse (2) vorgesehen Schwingungserregers (21) geführt wird.

12. Arbeitsmaschine nach einem der vorstehenden Ansprüche wobei
- die Kühlvorrichtung wenigstens zwei Lüftereinrichtungen (15) aufweist; und wobei
- die von den beiden Lüftereinrichtungen (15) erzeugten Luftströme zu einem gemeinsamen Kühlluftstrom (16) zusammenführbar sind.

13. Arbeitsmaschine nach einem der vorstehenden Ansprüche wobei stromauf von dem Energiespeicher (15) an einer Oberseite der Obermasse (1) eine Ansaugöffnung (32) für den Kühlluftstrom (16) vorgesehen ist.

## Claims

1. Work machine comprising:
- a work apparatus for effecting a work movement; and comprising
- a drive for driving the work apparatus;
wherein
- the drive has an electric drive motor (5), an electric energy storage device (10) for supplying the drive motor (5) with electric current, and a converter device (11) for converting the current from the energy storage device (10) and for supplying the current to the drive motor (5);
- a cooling device is provided for cooling the energy storage device (10) and the converter device (11);
- the cooling apparatus has at least one fan device (15) for generating a cooling airflow (16) which can be guided via the energy storage device (10) and the converter device (11);
- the fan device (15) has a fan and a fan motor which drives the fan;
- the fan motor is provided separately from the drive motor (5) of the drive;
- an upper mass (1) and a lower mass (2) are provided;
- the lower mass (2) is movable relative to the upper mass (1);
- the energy storage device (10), the converter device (11) and the cooling apparatus are arranged on the upper mass (1);
- a ground contact plate (4) for carrying out the work movement is provided on the lower mass (2), **characterised in that**
- an air-guiding device (30) is provided on the upper mass (1);
- the cooling airflow (16) is guided at least partially by the air-guiding device (30); and wherein
- the air-guiding device (30) supports the converter device (11).

2. Work machine as claimed in claim 1, wherein the cooling airflow (16) is guided between the energy storage device (10) and the converter device (11).

3. Work machine as claimed in any one of the preceding claims, wherein the fan is arranged in the cooling airflow (16) between the energy storage device (10) and the converter device (11).

4. Work machine as claimed in any one of the preceding claims, wherein a vibration-decoupling device is provided between the air-guiding device (30) and the remaining upper mass (1).

5. Work machine as claimed in any one of the preceding claims, wherein
- the energy storage device (10) is held in a storage battery receptacle;
- the storage battery receptacle and the air-guiding device (30) are coupled to one another; and wherein
- the storage battery receptacle and the air-guiding device (30) are jointly fastened to the upper mass (1) in a manner which is vibration-decoupled by means of the vibration-decoupling device.

6. Work machine as claimed in any one of the preceding claims, wherein
- the air-guiding device (30) has a support structure and a cover device which can be assembled together to form a unit;
- the support structure is configured to support the fan device (15) and the converter device (11); and wherein
- the support structure and the cover device form, in the assembled state, an air duct which extends at least between the fan device (15) and the converter device (11).

7. Work machine as claimed in any one of the preceding claims, wherein the support structure can be fastened to the upper mass (1) as a unit together with the fan device (15) and the converter device (11).

8. Work machine as claimed in any one of the preceding claims, wherein the air-guiding device (30) has an air entry opening (33) which is provided upstream of the fan device (15) and can be arranged downstream of the energy storage device (10).

9. Work machine as claimed in any one of the preceding claims, wherein the air-guiding device (30) has an air exit opening (31) which is provided downstream of the converter device (11) and is directed downwards.

10. Work machine as claimed in any one of the preceding claims, wherein an opening, through which the air-guiding device (30) extends downwards in the direction of the lower mass (2), is provided in the upper mass (1).

11. Work machine as claimed in any one of the preceding claims, wherein
- the lower mass (2) has a vibration exciter (21), which is arranged on the ground contact plate (4), for generating vibrations which can be utilised by the ground contact plate (4) for the purpose of ground compaction; and wherein
- the cooling airflow (16) exits via the air exit opening (31) and is guided in the direction of the vibration exciter (21) which is provided on the lower mass (2).

12. Work machine as claimed in any one of the preceding claims, wherein
- the cooling apparatus has at least two fan devices (15); and wherein
- the airflows generated by the two fan devices (15) can be merged to form a common cooling airflow (16).

13. Work machine as claimed in any one of the preceding claims, wherein an intake opening (32) for the cooling airflow (16) is provided upstream of the energy storage device (15) on an upper side of the upper mass (1).

## Revendications

1. Machine de travail, avec
- un dispositif de travail pour effectuer un mouvement de travail ; et avec
- un entraînement pour entraîner le dispositif de travail ;
dans laquelle
- l'entraînement comprend un moteur électrique (5), un accumulateur d'énergie électrique (10) pour alimenter le moteur d'entraînement (5) en courant électrique et un dispositif de transformation (11) pour convertir le courant provenant de l'accumulateur d'énergie (10) et l'acheminer vers le moteur d'entraînement (5) ;
- un dispositif de refroidissement est prévu pour refroidir l'accumulateur d'énergie (10) et le dispositif de transformation (11) ;
- le dispositif de refroidissement présente au moins un dispositif de ventilation (15) destiné à générer un flux d'air de refroidissement (16) pouvant être acheminé via l'accumulateur d'énergie (10) et le dispositif de transformation (11) ;
- le dispositif de ventilation (15) présente un ventilateur et un moteur de ventilateur entraînant le ventilateur ;
- le moteur de ventilateur est prévu séparément du moteur d'entraînement (5) de l'entraînement ;
- une masse supérieure (1) et une masse inférieure (2) sont prévues ;
- la masse inférieure (2) peut être déplacée par rapport à la masse supérieure (1) ;
- l'accumulateur d'énergie (10), le dispositif de transformation (11) et le dispositif de refroidissement sont agencés sur la masse supérieure (1) ;
- une plaque de contact au sol (4) est prévue sur la masse inférieure (2) pour exécuter le mouvement de travail ; **caractérisée en ce que**
- un dispositif de guidage d'air (30) est prévu sur la masse supérieure (1) ; le flux d'air de refroidissement (16) est acheminé au moins en partie via le dispositif de guidage d'air (30) ; et
- le dispositif de guidage d'air (30) supporte le dispositif de transformation (11).

2. Machine de travail selon la revendication 1, le flux d'air de refroidissement (16) étant acheminé entre l'accumulateur d'énergie (10) et le dispositif de transformation (11).

3. Machine de travail selon l'une des revendications précédentes, le ventilateur étant agencé dans le flux d'air de refroidissement (16) entre l'accumulateur d'énergie (10) et le dispositif de transformation (11).

4. Machine de travail selon l'une des revendications précédentes, dans laquelle un dispositif de découplage des vibrations est prévu entre le dispositif de guidage d'air (30) et le reste de la masse supérieure (1).

5. Machine de travail selon l'une des revendications précédentes, dans laquelle
- l'accumulateur d'énergie (10) est maintenu dans un logement de batterie ;
- le logement de batterie et le dispositif de guidage d'air (30) sont couplés l'un à l'autre ; et
- le logement de batterie et le dispositif de guidage d'air (30) sont fixés ensemble à la masse supérieure (1) de manière découplée en vibrations via le dispositif de découplage des vibrations.

6. Machine de travail selon l'une des revendications précédentes, dans laquelle
- le dispositif de guidage d'air (30) comprend une structure de support et un dispositif de couverture qui peuvent être assemblés pour former une unité ;
- la structure de support étant conçue pour supporter le dispositif de ventilation (15) et le dispositif de transformation (11) ; et dans laquelle
- la structure de support et le dispositif de couverture forment, à l'état assemblé, un canal d'air qui s'étend au moins entre le dispositif de ventilation (15) et le dispositif de transformation (11).

7. Machine de travail selon l'une des revendications précédentes, la structure de support pouvant être fixée à la masse supérieure (1) pour former une unité avec le dispositif de ventilation (15) et le dispositif de transformation (11).

8. Machine de travail selon l'une des revendications précédentes, dans laquelle le dispositif de guidage d'air (30) comporte une ouverture d'entrée d'air (33) prévue en amont du dispositif de ventilation (15), qui peut être agencée en aval de l'accumulateur d'énergie (10).

9. Machine de travail selon l'une des revendications précédentes, dans laquelle le dispositif de guidage d'air (30) présente une ouverture de sortie d'air (31) prévue en aval du dispositif de transformation (11) et orientée vers le bas.

10. Machine de travail selon l'une des revendications précédentes, dans laquelle une ouverture est prévue dans la masse supérieure (1), à travers laquelle le dispositif de guidage d'air (30) s'étend vers le bas en direction de la masse inférieure (2).

11. Machine de travail selon l'une des revendications précédentes, dans laquelle
- la masse inférieure (2) présente un générateur de vibrations (21) disposé sur la plaque de contact au sol (4) pour produire des vibrations qui peuvent être utilisées par la plaque de contact au sol (4) pour compacter le sol ; et dans laquelle
- le flux d'air de refroidissement (16) s'échappe par l'ouverture de sortie d'air (31) et est acheminé en direction du générateur de vibrations (21) prévu sur la masse inférieure (2).

12. Machine de travail selon l'une des revendications précédentes, dans laquelle
- le dispositif de refroidissement présente au moins deux dispositifs de ventilation (15) ; et
dans laquelle
- les flux d'air générés par les deux dispositifs de ventilation (15) peuvent être réunis en un flux d'air de refroidissement commun (16).

13. Machine de travail selon l'une des revendications précédentes, dans laquelle, en amont de l'accumulateur d'énergie (15), une ouverture d'aspiration (32) pour le flux d'air de refroidissement (16) est prévue sur une face supérieure de la masse supérieure (1).
